# EUROPEAN PATENT SPECIFICATION

(11) **EP 0 400 150 B1**
(45) Date of publication and mention of the grant of the patent: **10.11.1993**
(21) Application number: 89903249.4
(22) Date of filing: 02.03.1989
(51) Int. Cl.: H05K 7/14, H05K 5/02, H01R 13/633

(54) **I/O MODULE**
I/O Modul
MODULE D'ENTREE/SORTIE

(30) Priority: 12.03.1988 JP 59163/88
(43) Date of publication of application: 05.12.1990
(73) Proprietor: FANUC LTD., Minamitsuru-gun, Yamanashi 401-05 (JP)
(72) Inventor: INOUE, Michiya, Hachioji-shi, Tokyo 192 (JP); YAMAUCHI, Takashi, FanucMansionHarimomi 6-202, Minamitsuru-gun, Yamanashi 401-05 (JP)
(74) Representative: Jackson, Peter Arthur
(86) International application number: JP8900221
(87) International publication number: WO8908974

(56) References cited:
- EP-A- 0 165 434
- JP-A-57 123 670
- JP-U-56 109 287
- JP-Y-51 026 682
- JP-Y-59 010 784
- US-A- 3 992 654

## Description

The present invention relates to an input/output module (I/O module) for an electronic apparatus, and more specifically, to an I/O module for a programmable control device (PC).

An I/O module for a PC uses a terminal block for connecting a lot of input/output signals. Since this terminal block includes many wirings fixed by screws, it is usually arranged as a connector to be mounted and dismounted as a whole without removing the wirings to facilitate the replacement of a faulty I/O module. When this terminal block type connector is engaged, its receptacle must be strongly coupled with its plug. Thus, the opposite ends of the connector is conventionally locked by lever type latches or fixed by screws.

However, the method of coupling the connector by the screws has a drawback in that it takes a long time and is troublesome to tighten and loosen the screws and the method does not have an effect to push out the mounting/dismounting unit of the connector. Further, the lever used in the lever type latch is necessarily made large in size and the operation area thereof is increased to provide a sufficient push out effect. As a result, there is a strong request for an I/O module capable of being arranged in a small space at a high density and then the connector unit thereof is preferably small in size and light in weight.

Taking the above into consideration, a first object of the present invention is to provide an I/O module having a small and light connector unit capable of being easily mounted and dismounted.

Another object of the present invention is to provide an I/O module of safety wherein a charged portion of a terminal block is not exposed to a surface.

Still another object of the present invention is to provide an I/O module having an outside surface without wirings exposed thereon thereby to further enhance safety in consideration of the present state that a terminal block and many exposed wirings connected thereto give a very complicated appearance, particularly when many I/O modules are mounted at a high density, and they may cause an accident due to a human factor.

To solve the above problem, in accordance with the present invention, an I/O module for an electronic apparatus composed of a fixed unit provided with a box having opposite sides parallel to each other, a multiplicity of connection terminals disposed on a surface perpendicular to the opposite sides of the box and an LED display module unit disposed on a surface parallel to the surface on which the connection terminals are disposed and a mounting/dismounting unit having a terminal block including connection terminals capable of being engaged with the connection terminals of the fixed unit, a hinge disposed on one end of the mounting/dismounting unit, and a pin provided with the fixed unit and capable of being engaged with the hinge, (as disclosed in EP-A-0 165 434) is characterised by a grip provided with the mounting/dismounting unit and capable of being accommodated therein, wherein when the grip is pulled out to a position to be used and then further pulled out, the mounting/dismounting unit is moved, drawing an arc about the pin,and separated from the fixed unit.

Further, lever type latches may be disposed on a side opposite to the pin of the connector of the fixed unit to enable the mounting/dismounting unit to be more easily separated and locked. Since the lever type latch having a small pushing out effect sufficiently serves for this purpose, the size thereof can be small.

Furthermore, a case having a door is preferably provided with the mounting/dismounting unit including the terminal block. Since the lever may have a small size, as described above, the mounting/dismounting unit can be accommodated in the case.

In addition, when the connection terminals of the mounting/dismounting unit is engaged with the connection terminals of the fixed unit, the opposite sides of the case are preferably flush with the corresponding sides of the box of the fixed unit, respectively and the outside of the door of the case is preferably flush with the surface of the LED display module unit of the fixed unit at the closed position of the door.

The wirings are fixed on the terminal block by screws and pulled out to the outside from under the case. When a wiring job is completed, the door can be closed. To remove the mounting/dismounting unit, the door is opened and the grip is picked out to this side, then further pulled out and then the pin is separated from the hinge.

In the accompanying drawings:
Figure 1 is a perspective view of an I/O module and a back panel on which the I/O module is mounted of an embodiment according to the present invention;
Figure 2 is an exploded perspective view of the I/O of Figure 1;
Figures 3 and 4 are plan views of a terminal block mounted on a mounting/dismounting unit shown in Figure 2;
Figure 5 is an elevational view, partly in cross section of a connector unit of a fixed unit shown in Figure 2; and
Figures 6 is an elevational view of the terminal block shown in Figures 3 and 4.

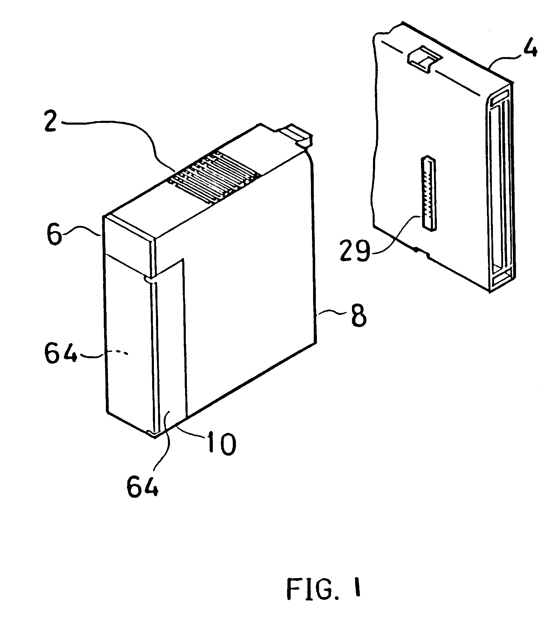

Figure 1 are perspective views of an I/O module 2 and a back panel 4 on which the I/O module according to the present invention is mounted. The I/O module 2 comprises a fixed unit 8 including an LED display module unit 6 and a mounting/dismounting unit 10.

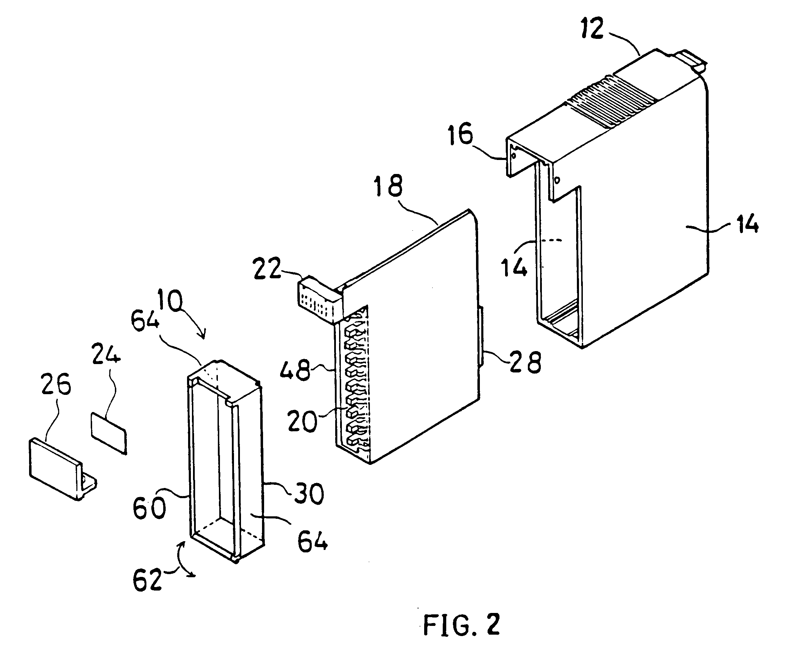

As shown in Figure 2, a box 12 of the fixed unit 8 is provided with opposite sides 14 which are parallel each other and a pent-roof portion 16. A printed circuit board 18 is provided with many connection terminals 20 and an LED display module 22. A file 24 and a protection cap 26 are attached on the front surface of the LED display module 22 so as to form the LED display module unit 6. The printed circuit board 18 is fixed in the box 12 in such a manner that the LED display module 6 is exactly accommodated in the pent-roof portion to form the fixed unit 8.

The fixed unit 8 is coupled with connection units 29 (only one of them is shown) disposed on the back panel 4 by a connection unit 28 attached to the rear end of the printed circuit board 18.

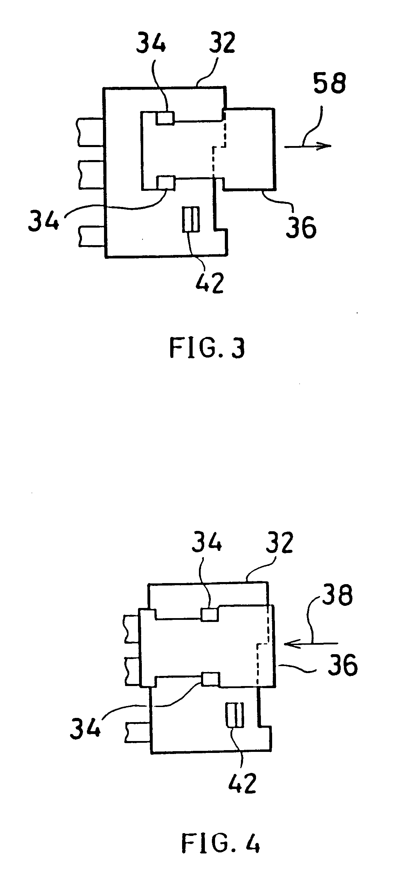

The mounting/dismounting unit 10 comprises a terminal block 32 arranged as a connector mounted in a case 30 (refer to Figures 3, 4 and 6).

Figure 3 is a plan view of the terminal block 32 and shows a grip 36 pulled out to the position where it is abutted against two locking portions 34.

Figure 4 is a plan view of the terminal block and shows the state that the grip 36 is pushed in the direction shown by the arrow 38 until it is abutted against the locking portions 34 and then it is accommodated in the mounting/dismounting unit.

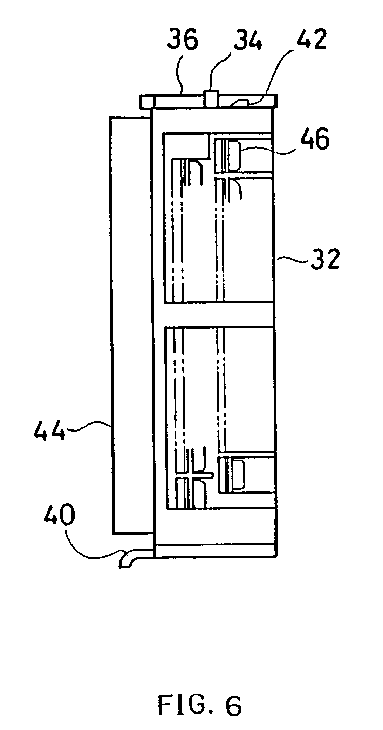

Figure 6 is an elevational view of the terminal block 32 shown in Figures 3 and 4, wherein a hinge 40 is disposed on the lower end of the terminal block 32 and a lug 42 is disposed on the upper end thereof. In addition, the terminal block 32 is provided with an insulation member 44 including connection terminals (not shown) capable of being connected to the connection terminals 20 of the fixed unit and many terminal screws 46.

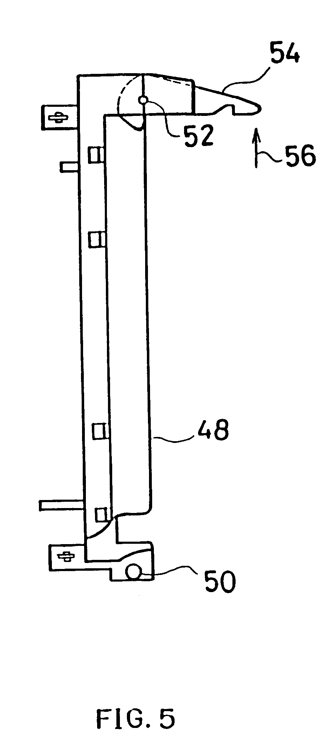

Figure 5 is an elevational view, partly in cross section of only the connector unit 48 of the fixed unit 8 illustrative of this embodiment, wherein a pin 50 is disposed on the lower end of the connector unit 48 and a shaft 52 and a lever type latch 54 are disposed on the upper end thereof and the latch 54 can be swung about the shaft 52.

In order to attach the mounting/dismounting unit 10 to the fixed unit 8, first, the hinge 40 is engaged with the pin 50, and then the mounting/dismounting unit 10 is pressed onto the fixed unit 8. Looseness can be prevented by causing the lever type latch 54 to be engaged with the lug 42.

In order to remove the mounting/dismounting unit 10, first, the extreme end of the lever type latch 54 is pushed upwardly in the direction shown by an arrow 56 to thereby release the engagement thereof with the lug 42 and to push out the mounting/dismounting unit 10 a little toward this side by the action of levers. Next, the grip 36 is pulled out to the position shown in Figure 3, i.e., the position where it is used and then it is further pulled out in the direction shown by an arrow 58. Thus, the mounting/dismounting unit 10 is moved, drawing an arc about the pin 50. Next, the hinge 40 is pulled and released from the pin 50 to separate the mounting/dismounting unit 10.

The case 30 is provided with a door 60 which can be opened and closed in the direction shown by an arrow 62.

As shown in Figure 1, when the connector of the fixed unit 8 is engaged with the connector of the mounting/dismounting unit 10, the opposite sides 64 of the case 30 are flush with the corresponding sides 14 of the box 12 and the outside surface of the door 60 of the case 30 is flush with the surface of the LED display module unit 6 of the fixed portion 8 at the closed position of the door 60.

In this embodiment, although the connector unit is provided with the lever type latches, it may be omitted.

In addition, any one of the connection terminals of the fixed unit and the mounting/dismounting unit may be the plug side or the receptacle side.

As described above, according to the present invention, the connector unit of the I/O module can be made small in size and light in weight and easily mounted and dismounted.

Further, since the charged portion of the terminal block is not exposed, safety is enhanced. Furthermore, since the outside appearance of the I/O module is made flat without irregularity, it can be easily handled and maintained and a colored label or the like can be attached on the surface of the door.

## Claims

1. An I/O module (2) for an electronic apparatus, composed of a fixed unit (8) provided with a box (12) having opposite sides (14) parallel to each other, a multiplicity of connection terminals (20) disposed on a surface perpendicular to the opposite sides of the box and an LED display module unit (6) disposed on a surface parallel to the surface on which the connection terminals are disposed and a mounting/dismounting unit (10) having a terminal block (32) including connection terminals capable of being engaged with the connection terminals of the fixed unit, a hinge (40) disposed on one end of said mounting/dismounting unit (10); and a pin (50) provided with said fixed unit (8) and capable of being engaged with said hinge (40); characterised
by a grip (36) provided with said mounting/dismounting unit (10) and capable of being accommodated therein, wherein when said grip (36) is pulled out to a position to be used and then further pulled out, said mounting/dismounting unit (10) is moved, drawing an arc about said pin (50) and separated from said fixed unit (8).

2. An I/O module according to claim 1,
wherein a lever type latch (54) is provided with a side opposite to said pin (40) of said fixed unit (8).

3. An I/O module according to claim 1 or 2,
wherein a case (30) having a door (60) is provided with said mounting/dismounting unit (10); and when said terminal block (32) of said mounting/dismounting unit is attached to said case (30) and said connection terminals of said mounting/dismounting unit (10) are engaged with said connection terminals (20) of said fixed unit (8), both sides of said case are flush with the corresponding sides (14) of said box (12), respectively and the outside surface of said door of said case is flush with the surface of said LED display module (6) of said fixed unit (8) at the closed position of said door (60).

## Patentansprüche

1. I/O-Modul (2) für ein elektrisches Gerät, mit einem festen Teil (8), dessen Gehäuse (12) parallele Seiten (14) und mehrere Anschlüsse (20) auf einer zu den Seiten des Gehäuses liegenden Fläche aufweist, und mit einem LED-Anzeigemodul (6) auf einer zur Fläche der Anschlüsse parallelen Fläche und mit einer lösbaren Einheit (10) mit einer Anschlußleiste (32) mit Anschlüssen zum Verbinden mit Anschlüssen des festen Teils, wobei ein Scharnier (40) an einem Ende der lösbaren Einheit (10) und ein Stift (50) an dem festen Teil (8) angeordnet sind, der von dem Scharnier (40) erfaßt wird, gekennzeichnet durch einen Griff (36) an der lösbaren Einheit (10), der in dieser aufnehmbar ist, wobei beim Herausziehen des Griffes (36) in eine Gebrauchslage und beim weiteren Herausziehen die lösbare Einheit (10) in einem Bogen um den Stift (50) bewegbar und von dem festen Teil (8) entfernbar ist.

2. I/O-Modul nach Anspruch 1, wobei eine hebelförmige Raste (54) an der dem Stift (50) des festen Teils (8) gegenüberliegenden Seite vorgesehen ist.

3. I/O-Modul nach Anspruch 1 oder 2, wobei die lösbare Einheit (10) mit einem Gehäuse (30) mit einer Tür (60) versehen ist, und beim Einbau der Anschlußleiste (32) der lösbaren Einheit in das Gehäuse (30) und beim Verbinden der Anschlüsse der lösbaren Einheit (10) mit den Anschlüssen (20) des festen Teils (8) beide Seiten des Gehäuses mit den entsprechenden Seiten (14) des Gehäuses (12) bündig sind und die Außenseite der Tür des Gehäuses mit der Oberfläche des LED-Anzeigemoduls (6) des festen Teils (8) bei geschlossener Tür bündig ist.

## Revendications

1. Un module E/S (2) pour un appareil électronique composé d'une unité fixe (8) munie d'un boîtier (12) présentant des côtés opposés (14) parallèles entre eux un ensemble de bornes de connexion (20) disposées sur une surface perpendiculaire aux côtés opposés du boîtier et une unité à module d'affichage DEL (6) disposée sur une surface parallèle à la surface sur laquelle sont disposées les bornes de connexion et une unité de montage/démontage (10) présentant un bloc de bornes (32) comprenant des bornes de connexion capables d'être mises en prise avec les bornes de connexion de l'unité fixe, une articulation (40) disposée sur une extrémité de ladite unité de montage/démontage (10) : et une broche (50) disposée avec ladite unité fixe (8) et susceptible d'être mise en contact avec ladite articulation (40) ; caractérisé
par une poignée (36) disposée avec ladite unité de montage/démontage (10) et susceptible d'être placée dans celle-ci, où lorsque ladite poignée (36) est tirée vers une position d'utilisation et ensuite ultérieurement poussée, ladite unité de montage/démontage (10) est déplacée , en décrivant un arc autour de ladite broche (50), et séparée de ladite unité fixe (8).

2. Un module E/S selon la revendication 1, dans lequel un verrou du type à levier (54) présente un côté oppose à ladite broche (40) de ladite unité fixe (8).

3. Un module E/S selon la revendication 1 ou 2, dans lequel un boîtier (30) présentant une porte (60) est muni de ladite unité de montage/démontage (10) ; et quand ledit bloc à bornes (32) de ladite unité de montage/démontage est fixé audit boîtier (30) et lesdites bornes de connexion de ladite unité de montage/démontage (10) sont en prise avec lesdites bornes de connexion (20) de ladite unité fixe (8), les deux côtés dudit boitier sont de niveau avec les côtés correspondants (14) dudit boîtier (12), respectivement, et la surface extérieure de ladite porte dudit boîtier est de niveau avec la surface dudit module d'affichage DEL (6) de ladite unité fixe (8) à la position fermée de ladite porte (60).
